# EUROPEAN PATENT APPLICATION

(11) **EP 4 770 293 A1**
(43) Date of publication of application: **01.07.2026**
(21) Application number: 24870189.8
(22) Date of filing: 15.08.2024
(51) Int. Cl.: H05K 7/20

(54) **HEAT DISSIPATION SYSTEM AND METHOD, AND DEVICE TO BE COOLED, ELECTRONIC DEVICE AND STORAGE MEDIUM**

(30) Priority: 27.09.2023 CN 202311283463
(71) Applicant: ZTE CORPORATION, Shenzhen, Guangdong 518057 (CN)
(72) Inventor: WANG, Xiaowu, Shenzhen, Guangdong 518057 (CN); LIU, Kai, Shenzhen, Guangdong 518057 (CN)
(74) Representative: Canzler & Bergmeier Patentanwälte Partnerschaft mbB
(86) International application number: PCT/CN2024/112281
(87) International publication number: WO 2025/066641

(57) **Abstract**

Provided in the embodiments of the present disclosure are a heat dissipation system and method, and a device to be cooled, an electronic device and a storage medium. The system comprises: a piezoelectric heat dissipation apparatus (1), a natural heat dissipation apparatus (2), a temperature sensor (3) and a control unit (4), wherein the piezoelectric heat dissipation apparatus (1) and the natural heat dissipation apparatus (2) are arranged on a heat source (5), and the control unit (4) is electrically connected to the temperature sensor (3) and the piezoelectric heat dissipation apparatus (1); the temperature sensor (3) measures the temperature of the heat source; the natural heat dissipation apparatus (2) performs natural heat dissipation; the piezoelectric heat dissipation apparatus (1) performs natural heat dissipation and performs airflow heat dissipation by means of a piezoelectric effect; and the control unit (4) acquires the temperature of the heat source, controls, when the temperature of the heat source is greater than or equal to a preset temperature threshold, the piezoelectric heat dissipation apparatus (1) to operate and to generate an airflow so as to make the natural heat dissipation apparatus (2) and the piezoelectric heat dissipation apparatus (1) perform airflow heat dissipation, and controls, when the temperature of the heat source is less than the temperature threshold, the piezoelectric heat dissipation apparatus (1) to stop operating so as to make the natural heat dissipation apparatus (2) and the piezoelectric heat dissipation apparatus (1) perform natural heat dissipation.

## Description

### CROSS-REFERENCE TO RELATED APPLICATIONS

This application claims priority from Chinese patent application No. 202311283463.9, filed on September 27, 2023, the contents of which are incorporated herein by reference in its entirety.

### TECHNICAL FIELD

The present disclosure relates to the technical field of heat dissipation, and particularly relates to a heat dissipation system and method, and a device to be cooled, an electronic device and a storage medium.

### BACKGROUND

The existing electronic products are characterized by powerful functions and small volume. For example: wireless household products such as routers, switches and optical modems have very powerful functions, and televisions, computers, tablets, mobile phones and the like need to be connected to routers, switches and the like. These electronic products have the problems of high power consumption and heat generation in use.

### SUMMARY

Embodiments of the present disclosure provide a heat dissipation system and method, and a device to be cooled, an electronic device and a storage medium.

In a first aspect, an embodiment of the present disclosure provides a heat dissipation system, including a piezoelectric heat dissipation apparatus, a natural heat dissipation apparatus, a temperature sensor, and a control unit; wherein the piezoelectric heat dissipation apparatus and the natural heat dissipation apparatus are disposed on a heat source of a device to be cooled, and the control unit is electrically connected to the temperature sensor and the piezoelectric heat dissipation apparatus, respectively; the temperature sensor is configured to sense a temperature of the heat source; the natural heat dissipation apparatus is configured to conduct natural heat dissipation; the control unit is configured to acquire the temperature of the heat source, and control, under the condition that the temperature of the heat source is higher than or equal to a preset temperature threshold, the piezoelectric heat dissipation apparatus to operate and generate an airflow, so that the natural heat dissipation apparatus and the piezoelectric heat dissipation apparatus conduct airflow heat dissipation; and control, under the condition that the temperature of the heat source is lower than the temperature threshold, the piezoelectric heat dissipation apparatus to stop operating so that the natural heat dissipation apparatus and the piezoelectric heat dissipation apparatus conduct natural heat dissipation.

In a second aspect, an embodiment of the present disclosure further provides a heat dissipation method based on the heat dissipation system described above and applied to a control unit of the heat dissipation system, wherein the method includes: acquiring a temperature of a heat source in a device to be cooled; under the condition that the temperature of the heat source is higher than or equal to a preset temperature threshold, controlling a piezoelectric heat dissipation apparatus of the heat dissipation system to operate and generate an airflow, so that the natural heat dissipation apparatus and the piezoelectric heat dissipation apparatus conduct airflow heat dissipation; and under the condition that the temperature of the heat source is lower than the temperature threshold, controlling the piezoelectric heat dissipation apparatus to stop operating so that the natural heat dissipation apparatus and the piezoelectric heat dissipation apparatus conduct natural heat dissipation.

In a third aspect, an embodiment of the present disclosure provides a device to be cooled, including: the heat dissipation system described above.

In a fourth aspect, an embodiment of the present disclosure provides an electronic device, including: one or more processors; a memory having one or more programs stored thereon which, when executed by the one or more processors, cause the one or more processors to conduct the heat dissipation method as described above; and one or more input/output, I/O interfaces connected between the one or more processors and the memory and configured to enable information interaction between the one or more processors and the memory.

In a fifth aspect, an embodiment of the present disclosure provides a computer-readable storage medium having a computer program stored thereon which, when executed by a processor, causes the heat dissipation method described above to be implemented.

### BRIEF DESCRIPTION OF DRAWINGS

In the drawings of the embodiments of the present disclosure:
FIG. 1 is a block diagram of a heat dissipation system according to an embodiment of the present disclosure;
FIG. 2 is a block diagram of a piezoelectric heat dissipation apparatus according to an embodiment of the present disclosure;
FIG. 3 is a schematic diagram showing a first fin disposed on a second fin according to an embodiment of the present disclosure;
FIG. 4 is a schematic diagram showing correspondence among different temperature levels, different swinging frequency levels and opened and closed states of a window in a heat source temperature rise scene according to an embodiment of the present disclosure;
FIG. 5 is a schematic diagram showing correspondence among different temperature levels, different swinging frequency levels and opened and closed states of a window in a heat source temperature drop scene according to an embodiment of the present disclosure;
FIG. 6 is a schematic diagram showing connection of a window control apparatus according to an embodiment of the present disclosure;
FIG. 7 is a block diagram of a window control apparatus according to an embodiment of the present disclosure;
FIG. 8 is a flowchart of a heat dissipation method according to an embodiment of the present disclosure;
FIG. 9 is a block diagram of a device to be cooled according to an embodiment of the present disclosure;
FIG. 10 is a block diagram of an electronic device according to an embodiment of the present disclosure; and
FIG. 11 is a block diagram of a computer-readable storage medium according to an embodiment of the present disclosure.

### DETAIL DESCRIPTION OF EMBODIMENTS

To improve understanding of the technical solutions of the present disclosure for those skilled in the art, the heat dissipation system and method, the device to be cooled, the electronic device and the storage medium provided in the embodiments of the present disclosure will be described below in detail in conjunction with the accompanying drawings.

The present disclosure will be described more sufficiently below with reference to the accompanying drawings, where the illustrated embodiments may be embodied in different forms. However, the present disclosure should not be construed as being limited to the embodiments set forth herein. Rather, these embodiments are provided so that the present disclosure will be thorough and complete, and will fully convey the scope of the present disclosure to those skilled in the art.

Accompanying drawings are provided for further understanding of the embodiments of the present disclosure and constitute a part of the specification. Hereinafter, these drawings are intended to explain the present disclosure together with the detailed embodiments, but should not be considered as a limitation to the present disclosure. The above and other features and advantages will become more apparent to those skilled in the art by describing the detailed embodiments with reference to the accompanying drawings.

Embodiments of the present disclosure and features thereof may be combined with each other without conflict.

The terminology used herein is for the purpose of describing specific embodiments only and is not intended to limit the present disclosure. As used herein, the term "and/or" includes any and all combinations of one or more of the associated listed items. As used herein, the singular forms "a", "an" and "the" are intended to include the plural forms as well, unless the context clearly indicates otherwise. As used herein, the terms "comprise" and "consist of..." specify the presence of the stated features, integers, steps, operations, elements, and/or components, but do not preclude the presence or addition of one or more other features, integers, steps, operations, elements, components, and/or groups thereof.

Unless otherwise defined, all terms (including technical and scientific terms) used in the present disclosure have the same meaning as commonly understood by one of ordinary skill in the art. It will be further understood that terms, such as those defined in commonly used dictionaries, should be interpreted as having a meaning that is consistent with their meaning in the context of the existing art and the present disclosure, and will not be interpreted in an idealized or overly formal sense unless expressly so defined in the present disclosure.

Current electronic products, especially wireless household products such as routers, switches, optical modems and the like, are very powerful and lightweight, and televisions, computers, tablets, mobile phones and the like need to be connected to routers, switches and the like, especially household router products. Almost all smart devices are associated with routers or optical modems. However, such household products are characterized by high power consumption and serious heat generation, and users usually have a hot touch feeling, and even worry about the safety of the products.

With the development of the household products with smaller and smaller sizes, users pay more attention to heat generation of the device. Poor heat dissipation may lead to heat constantly accumulated in the housing, which may directly affect the actual performance and lifetime of the product, as well as the actual experience of users. Therefore, a good heat dissipation system can effectively improve the service life and actual performance of the product, and allow better experience of customers.

The heat dissipation structure in current household products (such as a household router) mainly adopts a natural heat dissipation structure or a forced heat dissipation structure. The natural heat dissipation structure mainly relies on fins for heat dissipation, so that heat in a chip and the structure can be radiated out, while the forced heat dissipation structure mainly implement heat dissipation by adding a fan arrangement on the fins, so that the heat on/in the fins can be taken away quickly, and thereby the temperature of the whole device can be effectively reduced.

The natural heat dissipation apparatus is simple, and basically implemented by adding various shapes of heat sinks on the circuit, such as a flat plate heat sink, a toothed heat sink and the like. The household product is characterized by being silent and noise-free, and to this end, most of the conventional devices adopt a natural heat dissipation apparatus, where heat dissipation is implemented by fins solely, leading to the defect of limited heat dissipation capability for high-power-consumption devices. The forced heat dissipation is generally adopted in certain high-end products, where a fan is added on the basis of the fins, through which the heat of the fins can be radiated out quickly. However, the fan has the defects of large noise, short service life and easy damage after long-time operation. On the other hand, the household product typically has a long service cycle, and once the fan has an exception, the device may be overheated and exposed to possible damage.

Considering the stability and silence (no noise from a router or an optical modem) of the household product, a solution provided in an embodiment of the present disclosure proposes a novel heat dissipation scheme which solves not only the problem of slow natural heat dissipation, but also the overheating of the product, and can effectively reduce the power consumption and temperature of the product and ensure the system stability of the product.

The heat dissipation system provided in the embodiment of the present disclosure can be applied to any product that needs heat dissipation, especially a product that needs silent heat dissipation, which may include, but is not limited to, a vehicle-mounted device, a user equipment (UE), a mobile device, a computing device, and the like. The user equipment may include, but is not limited to, a household communication relay device (e.g., a router, an optical modem, and the like), a household appliance, and the like. The heat dissipation method provided in the embodiments of the present disclosure maybe implemented by a processor calling computer-readable program instructions stored in a memory, or may be implemented by a server.

Solutions provided in the embodiments of the present disclosure are described in detail below.

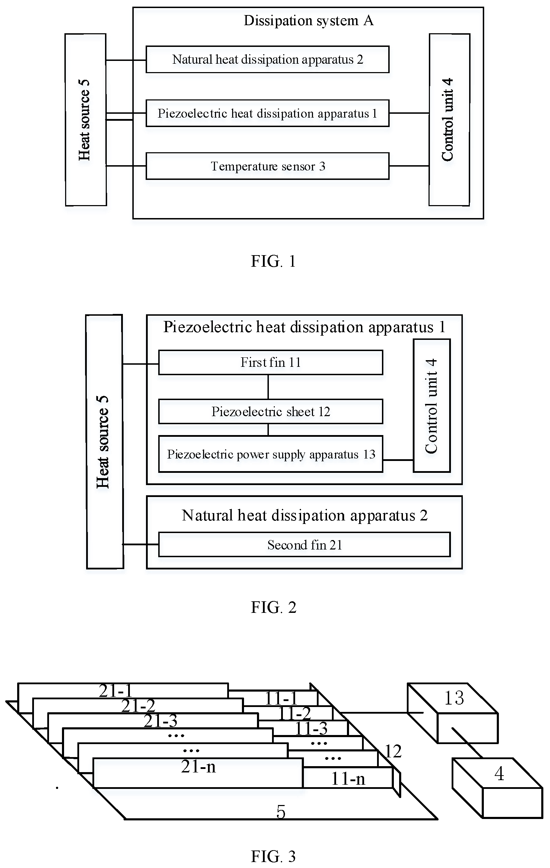

An embodiment of the present disclosure provides a heat dissipation system A, which, as shown in FIG. 1, includes: a piezoelectric heat dissipation apparatus 1, a natural heat dissipation apparatus 2, a temperature sensor 3, and a control unit 4. The piezoelectric heat dissipation apparatus 1 and the natural heat dissipation apparatus 2 are disposed on a heat source 5 of a device to be cooled (or called device requiring heat dissipation) B, and the control unit 4 is electrically connected to the temperature sensor 3 and the piezoelectric heat dissipation apparatus 1, respectively. The temperature sensor 3 is configured to sense a temperature of the heat source. The natural heat dissipation apparatus 2 is configured to conduct natural heat dissipation. The piezoelectric heat dissipation apparatus 1 is configured to conduct natural heat dissipation, and conduct airflow heat dissipation by means of a piezoelectric effect. The control unit 4 is configured to acquire the temperature of the heat source, and control, under the condition that the temperature of the heat source is higher than or equal to a preset temperature threshold, the piezoelectric heat dissipation apparatus 1 to operate and generate an airflow, so that the natural heat dissipation apparatus 2 and the piezoelectric heat dissipation apparatus 1 conduct airflow heat dissipation; and control, under the condition that the temperature of the heat source is lower than the temperature threshold, the piezoelectric heat dissipation apparatus 1 to stop operating so that the natural heat dissipation apparatus 2 and the piezoelectric heat dissipation apparatus 1 conduct natural heat dissipation.

According to the heat dissipation system provided in the embodiments of the present disclosure, the piezoelectric heat dissipation apparatus can implement both airflow heat dissipation and natural heat dissipation, while the natural heat dissipation apparatus can implement natural heat dissipation, so that with the two apparatuses implementing heat dissipation jointly, the heat dissipation effect is guaranteed and rapid heat dissipation of the product can be implemented. The airflow heat dissipation implemented by the piezoelectric heat dissipation apparatus involves generating an airflow by means of a piezoelectric effect which may cause extremely low vibration noise, so that the product can also achieve a silencing effect during the airflow heat dissipation, thereby improving the user experience. In addition, compared with the conventional heat dissipation devices such as a fan, the piezoelectric heat dissipation apparatus has a smaller size, less occupied space, longer service life, and higher resistance to damage, and can be easily used for small products such as routers and optical modems. The heat dissipation system further includes a control unit which can adjust the heat dissipation scheme (implementing both airflow heat dissipation and natural heat dissipation, or implementing natural heat dissipation only) based on the temperature of the heat source, thereby implementing intelligent control of the heat dissipation system, so that heat can be dissipated and cooled quickly when the temperature is high, and the heat dissipation effect is guaranteed.

In the embodiments of the present disclosure, the heat source 5 may include, but is not limited to: a printed circuit board (PCB) in a device to be cooled, and a heat-generating component, such as a chip, provided on the PCB. The type, number, shape, size, structure and the like of the heat source 5 are not limited herein.

In the embodiments of the present disclosure, the composition structures of the piezoelectric heat dissipation apparatus 1 and the natural heat dissipation apparatus 2 are not limited, any device or component capable of achieving natural heat dissipation may be used as the natural heat dissipation apparatus 2, and any device or component capable of achieving heat dissipation by means of a piezoelectric effect may be used as the piezoelectric heat dissipation apparatus 1.

In the embodiments of the present disclosure, the natural heat dissipation apparatus 2 may include, but is not limited to, a flat plate heat sink, and a toothed heat sink.

In the embodiments of the present disclosure, the setting positions, numbers, layouts and the like of the piezoelectric heat dissipation apparatus 1 and the natural heat dissipation apparatus 2 on the heat source 5 are not limited, and may be customized or defined according to the requirement.

In an embodiment of the present disclosure, as shown in FIG. 2, the piezoelectric heat dissipation apparatus 1 may include, but is not limited to, at least one swingable first fin 11, a piezoelectric sheet 12 for driving the first fin 11 to swing, and a piezoelectric power supply apparatus 13. The first fin 11 is connected to the piezoelectric sheet 12, and the piezoelectric sheet 12 is electrically connected to the piezoelectric power supply apparatus 13. The control unit 4 is electrically connected to the piezoelectric power supply apparatus 13. The natural heat dissipation apparatus 2 may include at least one second fin 21.

In an embodiment of the present disclosure, the piezoelectric sheet 12 may be or include a metal sheet, may be powered by the piezoelectric power supply apparatus 13, and may generate vibration after being powered to drive the first fin 11 to swing.

In an embodiment of the present disclosure, to minimize the sound generated by the vibration of the piezoelectric sheet 12, the piezoelectric sheet 12 may be made of, or provided with, a muffling material.

In an embodiment of the present disclosure, the piezoelectric sheet 12 and the first fin 11 may be arranged integrally or separately. When arranged integrally with the piezoelectric sheet 12, the first fin 11 may be directly connected to the piezoelectric power supply apparatus 13 as the piezoelectric sheet 12, so that the first fin 11 vibrates after being powered on. When the piezoelectric sheet 12 and the first fin 11 are separately arranged as individual bodies, the first fin 11 is connected to the piezoelectric sheet 12, and the piezoelectric sheet 12 is further connected to the piezoelectric power supply apparatus 13.

In an embodiment of the present disclosure, one or more first fins 11 may be provided, and one or more second fins 21 may be provided, where the number of the first fins 11 and the number of the second fins 21 are not limited herein.

In an embodiment of the present disclosure, the first fin 11 and/or the second fin 21 may be directly or indirectly connected to the heat source 5 to conduct and dissipate heat generated from the heat source 5. For example, the first fin 11 and the second fin 21 may be disposed on the heat source 5 via preset heat dissipation pads.

In an embodiment of the present disclosure, the first fin 11 may be directly disposed on the heat source 5, disposed on the heat source 5 via a heat dissipation pad, or disposed on the second fin 21.

In an embodiment of the present disclosure, the first fin 11 may be disposed on one side, an upper portion, a top end, and the like of the heat source 5 and/or the second fin 21, and the detailed arrangement, position, number, and the like of the first fin 11 are not limited herein.

In an embodiment of the present disclosure, as shown in FIG. 3, the first fin 11 disposed on the second fin 21 is schematically shown. In FIG. 3, a plurality of second fins 21 (e.g., shown as 21-1, 21-2, 21-3, ..., 21-n, where n is a positive integer) are arranged in parallel, one side of each second fin 21 is connected to a respective first fin 11 (e.g., shown as 11-1, 11-2, 11-3, ..., 11-n), and the plurality of first fins 11 are all connected to a piezoelectric sheet 12.

In the embodiments of the present disclosure, since the first fin 11 requires a space for swinging, the space for swinging of the first fin 11 and a swingable portion of the first fin 11 should be reserved despite the position of the first fin 11. For example, the first fin 11 may be partially suspended above the heat source and/or the second fin 21.

In an embodiment of the present disclosure, the second fin 21 may be a toothed fin, for example, and a portion of a plurality of first fins 11 may be disposed on a plurality of teeth of the toothed fin at an upper or top end, so that the airflow takes away (dissipates) heat from an upper space of the toothed fins by swinging.

In an embodiment of the present disclosure, in the case of a plurality of first fins 11, each first fin 11 may be connected to one piezoelectric sheet 12, or a plurality of first fins 11 may be connected to the same piezoelectric sheet 12, where the number of piezoelectric sheets 12 is not limited here.

In an embodiment of the present disclosure, since the piezoelectric sheet 12 is generally thin, to allow the piezoelectric sheet 12 to drive the first fin 11 to swing when vibrating, the first fin 11 is also thin, where the specific thickness of the first fin 11 is not limited here as along as the first fin 11 can be moved with vibration of the piezoelectric sheet 12. The first fin 11 may be a flexible fin which can facilitate increasing the swing amplitude, driving a larger airflow and enhancing the heat dissipation effect.

In the embodiments of the present disclosure, based on the above arrangement, the temperature of the heat source 5 may be monitored in real time or periodically by the temperature sensor 3, and the control unit 4 may control power supply or power off of the piezoelectric heat dissipation apparatus 1 based on the detected temperature of the heat source, so as to control the operation or stop of the piezoelectric heat dissipation apparatus 1, thereby controlling the first fin 11 in the piezoelectric heat dissipation apparatus 1 to swing or stop, so that the piezoelectric heat dissipation apparatus 1 can implement both airflow heat dissipation and natural heat dissipation.

In an embodiment of the present disclosure, for example, under the condition that the temperature of the heat source is higher than or equal to a preset temperature threshold, the piezoelectric heat dissipation apparatus 1 is controlled to operate to generate an airflow, thereby taking away, with the airflow, heat that is conducted through the natural heat dissipation apparatus 2 and the piezoelectric heat dissipation apparatus 1, achieving both airflow heat dissipation and natural heat dissipation; and under the condition that the temperature of the heat source is lower than the temperature threshold, the piezoelectric heat dissipation apparatus 1 is controlled to stop operating so that the natural heat dissipation apparatus 2 and the piezoelectric heat dissipation apparatus 1 conduct natural heat dissipation.

In the embodiments of the present disclosure, according to this implementation, natural heat dissipation may be conducted when the temperature of the heat source 5 is lower, and airflow heat dissipation and natural heat dissipation may be conducted when the temperature of the heat source 5 is higher, thereby achieving the purposes of saving energy consumption when the temperature is low and rapidly cooling when the temperature is high.

In an embodiment of the present disclosure, the control unit 4 controlling the piezoelectric heat dissipation apparatus 1 to operate and generate an airflow, so that the natural heat dissipation apparatus 2 and the piezoelectric heat dissipation apparatus 1 conduct airflow heat dissipation includes: controlling the piezoelectric power supply apparatus 13 to supply power to the piezoelectric sheet 12, so that the piezoelectric sheet 12 vibrates to drive the first fin 11 to swing, and takes away heat from the first fin 11 and the second fin 21 through an airflow generated by the swing of the first fin 11.

The control unit 4 controlling the piezoelectric heat dissipation apparatus 13 to stop operating so that the natural heat dissipation apparatus 2 and the piezoelectric heat dissipation apparatus 1 conduct natural heat dissipation includes: controlling the piezoelectric power supply apparatus 13 to cut off power to the piezoelectric sheet 12, so that the piezoelectric sheet 12 stops vibrating, the first fin 11 stops swinging, and the first fin 11 and the second fin 21 conduct natural heat dissipation alone.

In the embodiment of the present disclosure, a main purpose of the control unit 4 controlling power supply or power off of the piezoelectric heat dissipation apparatus 1 is to control power supply or power off of the piezoelectric sheet 12 through the piezoelectric power supply apparatus 13, where the piezoelectric sheet 12 may vibrate when powered on and stop vibrating when powered off.

In an embodiment of the present disclosure, the control unit 4 may be further configured to adjust the supply voltage of the piezoelectric power supply apparatus 13 in accordance with the temperature of the heat source, so as to adjust a swinging frequency of the first fin 11 through a change in the supply voltage.

In an embodiment of the present disclosure, the heat source temperature may be divided into multiple levels, and the supply voltage of the piezoelectric power supply apparatus 13 may also be divided to multiple levels accordingly, so that the swinging frequency of the first fin 11 is also divided to multiple levels accordingly.

In an embodiment of the present disclosure, it is also possible to set multiple levels corresponding to rises and drops of the heat source temperature, respectively. The levels divided in a heat source temperature rise scene and a heat source temperature drop scene may be the same or different.

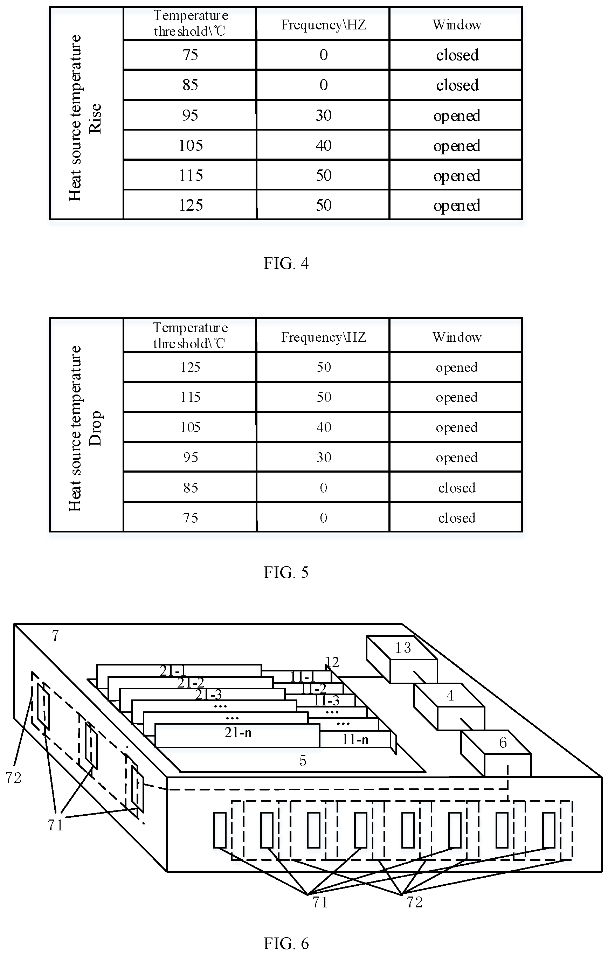

In an embodiment of the present disclosure, as shown in FIGs. 4 and 5, for example, in a heat source temperature rise scene, 6 levels, i.e., 75°C, 85°C, 95°C, 105°C, 115°C and 125°C may be set and correspond to 6 swinging frequencies, i.e., 0HZ, 0HZ, 30HZ, 40HZ, 50HZ and 50HZ, and the like, respectively. In a heat source temperature drop scene, 6 levels, i.e., 125°C, 115°C, 105°C, 95°C, 85°C and 75°C, and the like may be set and correspond to 6 swinging frequencies, i.e., 50HZ, 50HZ, 40HZ, 30HZ, 0HZ and 0HZ, and the like, respectively.

In an embodiment of the present disclosure, as shown in FIG. 6, the heat dissipation system A may further include: a window control apparatus 6. The window control apparatus 6 is electrically connected to the control unit 4.

The device B to be cooled may include a housing 7 which may be provided with at least one window 71 and a window baffle 72 for covering the window 71.

The window control apparatus 6 may be configured to control, under the control of the control unit 4, the window baffle 72 to move to open or close the window 71.

In an embodiment of the present disclosure, to improve the heat dissipation effect, at least one window 71 may be provided on the device B to be cooled for ventilation, where the shape, size, number, and position of the window may be customized or defined according to requirements.

In an embodiment of the present disclosure, to avoid affecting the device performance by too much dust accumulated inside the device B to be cooled caused by an electrostatic effect when the window 71 is provided, a window baffle 72 for blocking the window 71 may be provided. The window baffle 72 may be provided as a movable structure, which can be removed from the window 71 when the window 71 needs to be opened, and can block the window 71 when the window 71 does not need to be opened. The case where the window 71 needs to be opened may include, but is not limited to, a case where the temperature of the heat source 5 is too high and the heat needs to be dissipated quickly. By providing the window baffle 72, the purposes of quick heat dissipation and dust prevention can be achieved at the same time.

In an embodiment of the present disclosure, the control unit 4 may be further configured to, under the condition that the temperature of the heat source is higher than or equal to a temperature threshold, conduct first control on the window control apparatus 6 to control the window baffle 72 to open the window 71; and under the condition that the temperature of the heat source is lower than the temperature threshold, conduct second control on the window control apparatus 6 to control the window baffle 72 to close the window 71.

In an embodiment of the present disclosure, as discussed above, under the condition that the temperature of the heat source is higher than or equal to a preset temperature threshold, the piezoelectric heat dissipation apparatus 1 may be controlled to operate and generate an airflow, thereby taking away, with the airflow, the heat that is conducted through the natural heat dissipation apparatus 2 and the piezoelectric heat dissipation apparatus 1, achieving both airflow heat dissipation and natural heat dissipation; and after the piezoelectric heat dissipation apparatus 1 generates the airflow, if the housing 7 is in a closed state now, for example, the window 71 is closed, the airflow will flow only within the housing 7 and cannot exchange heat with outside air or achieve the purpose of rapid heat dissipation. Therefore, the airflow heat dissipation cannot be actually implemented, and thus, the window control apparatus 6 needs to be controlled (e.g., under the first control discussed above) to control the window baffle 72 to open the window 71.

In an embodiment of the present disclosure, under the condition that the temperature of the heat source is lower than the temperature threshold, the piezoelectric heat dissipation apparatus 1 is controlled to stop operating so that the natural heat dissipation apparatus 2 and the piezoelectric heat dissipation apparatus 1 conduct natural heat dissipation. Since the temperature of the heat source 5 is not high at this time, the natural heat dissipation apparatus 2 and the piezoelectric heat dissipation apparatus 1 only need to conduct natural heat dissipation. Therefore, even if there is a housing, natural heat dissipation can be achieved by slowly exchanging heat with the external surroundings through the housing 7. In this case, the window control apparatus 6 may also be controlled (e.g., under the second control discussed above) to control the window baffle 72 to open the window 71. Whether to open the window 71 may be determined based on a proper control policy selected according to the requirement.

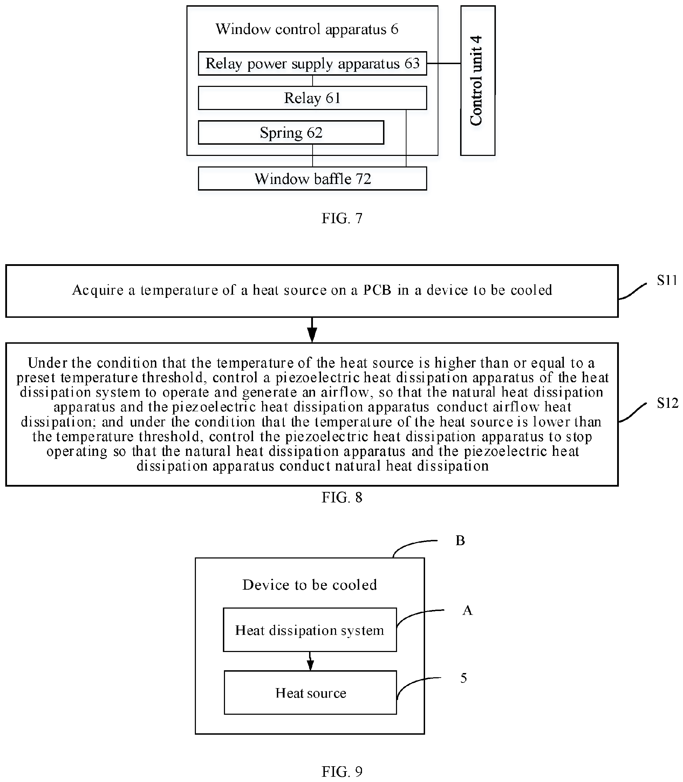

In an embodiment of the present disclosure, as shown in FIG. 7, the window control apparatus 6 may include, but is not limited to, a relay 61, a spring 62 and a relay power supply apparatus 63. The first end of the window baffle 72 is connected to the first end of the spring 62, and the second end of the spring 62 is fixed to the housing 7. The second end of the window baffle 72 is connected to the movable contact of the relay 61. The relay 61 is electrically connected to the relay power supply apparatus 63. The relay power supply apparatus 63 is electrically connected to the control unit 4.

In an embodiment of the present disclosure, the control unit 4 conducting first control on the window control apparatus 6 to control the window baffle 72 to open the window 71 includes: controlling the relay power supply apparatus 63 to supply power to the relay 61, so that the window baffle 72 is pulled to move in a first direction through pull-in of the relay 61, thereby opening the window 71.

The control unit 4 conducting second control on the window control apparatus 6 to control the window baffle 72 to close the window 71 includes: controlling the relay power supply apparatus 63 to cut off power to the relay 61, so that the spring 62 pulls the window baffle 72 to move in a second direction through release of the relay 61, thereby closing the window 71.

In an embodiment of the present disclosure, a connection rod may be provided on the window baffle 72. A rod body of the connection rod is fixed to the window baffle 72, one end of the connection rod is connected to the spring 62, and the other end of the connection rod is connected to the movable contact of the relay 61, so that when the relay 61 is energized and the movable contact is attracted to a stationary contact, the connection rod is pulled to drive the window baffle 72 to move. Similarly, when the relay 61 is deenergized and the movable contact is released from the stationary contact, the connection rod is pulled back by the spring to bring the window baffle 72 back to an original position.

In an embodiment of the present disclosure, when a plurality of windows 71 are provided on one side of the housing 7, each of the plurality of windows 71 may correspond to one window baffle 72, and all the window baffles 72 may be connected by the connection rod described above, so that all the window baffles 72 are moved together when the connection rod is moved.

In an embodiment of the present disclosure, under the condition that the temperature sensor 3 detects that the temperature of the heat source is higher than or equal to a temperature threshold, the control unit 4 controls the piezoelectric power supply apparatus 13 to output a voltage to the piezoelectric sheet 12, so that the piezoelectric sheet 12 starts to vibrate and drive the first fin 11 to swing. Further, the control unit 4 controls the relay power supply apparatus 63 to output a voltage to the relay 61, and the relay 61 with a voltage attracts the window baffle 72 to open the window 71, so that the airflow formed by the swinging first fin 11 flows out with the entrained heat through the window 71, thereby effectively solving the problem of high-power heat dissipation. Under the condition that the temperature sensor 3 detects that the temperature of the heat source is lower than the temperature threshold, the control unit 4 controls the piezoelectric power supply apparatus 13 to stop supplying power to the piezoelectric sheet 12, so that the piezoelectric sheet 12 stops vibrating, the first fin 11 stops swinging, and the first fin 11 conducts natural heat dissipation. Further, the control unit 4 controls the relay power supply apparatus 63 to stop supplying power to the relay 61, and the relay 61 without a voltage releases the window baffle 72, so that the window baffle 72 is pulled back by the spring 62 to close the window 71.

An embodiment of the present disclosure further provides a heat dissipation method which, as shown in FIG. 8, is based on the heat dissipation system A and applied to a control unit of the heat dissipation system A. The method includes the following operations S11 to S12.

In operation S11, a temperature of a heat source on a printed circuit board heat source in a device to be cooled is acquired.

In operation S12, under the condition that the temperature of the heat source is higher than or equal to a preset temperature threshold, a piezoelectric heat dissipation apparatus of the heat dissipation system is controlled to operate and generate an airflow, so that the natural heat dissipation apparatus and the piezoelectric heat dissipation apparatus conduct airflow heat dissipation; and under the condition that the temperature of the heat source is lower than the temperature threshold, the piezoelectric heat dissipation apparatus is controlled to stop operating so that the natural heat dissipation apparatus and the piezoelectric heat dissipation apparatus conduct natural heat dissipation.

In the embodiment of the present disclosure, controlling the piezoelectric heat dissipation apparatus of the heat dissipation system to operate and generate an airflow, so that the natural heat dissipation apparatus and the piezoelectric heat dissipation apparatus conduct airflow heat dissipation may include: controlling a piezoelectric power supply apparatus of the piezoelectric heat dissipation apparatus to supply power to a piezoelectric sheet of the piezoelectric heat dissipation apparatus, so that the piezoelectric sheet vibrates to drive a first fin of the piezoelectric heat dissipation apparatus to swing, and takes away heat from the first fin and a second fin of the natural heat dissipation apparatus through an airflow generated by the swing of the first fin.

In an embodiment of the present disclosure, controlling the piezoelectric heat dissipation apparatus to stop operating so that the natural heat dissipation apparatus and the piezoelectric heat dissipation apparatus conduct natural heat dissipation includes: controlling the piezoelectric power supply apparatus to cut off power to the piezoelectric sheet, so that the piezoelectric sheet stops vibrating, the first fin stops swinging, and the first fin and the second fin conduct natural heat dissipation alone.

In an embodiment of the present disclosure, the method may further include: adjusting a supply voltage of the piezoelectric power supply apparatus in accordance with the temperature of the heat source, so as to adjust a swinging frequency of the first fin through a change in the supply voltage.

In an embodiment of the present disclosure, the method may further include: under the condition that the temperature of the heat source is higher than or equal to a temperature threshold, conducting first control on a window control apparatus of the heat dissipation system to control a window baffle of the device to be cooled to open a window on a housing of the device to be cooled; and under the condition that the temperature of the heat source is lower than the temperature threshold, conducting second control on the window control apparatus to control the window baffle to close the window.

In an embodiment of the present disclosure, conducting first control on the window control apparatus of the heat dissipation system to control the window baffle of the device to be cooled to open the window on the housing of the device to be cooled includes: controlling a relay power supply apparatus of the window control apparatus to supply power to a relay of the window control apparatus, so that the window baffle is pulled to move in a first direction through pull-in of the relay, thereby opening the window; and conducting second control on the window control apparatus to control the window baffle to close the window includes: controlling the relay power supply apparatus to cut off power to the relay, so that a spring of the window control apparatus pulls the window baffle to move in a second direction through release of the relay, thereby closing the window.

In the embodiments of the present disclosure, any embodiment of the foregoing heat dissipation system is applicable to the embodiment of the heat dissipation method, and details are not repeated here.

An embodiment of the present disclosure further provides a device to be cooled B which, as shown in FIG. 9, may include: a heat source 5 and the heat dissipation system A.

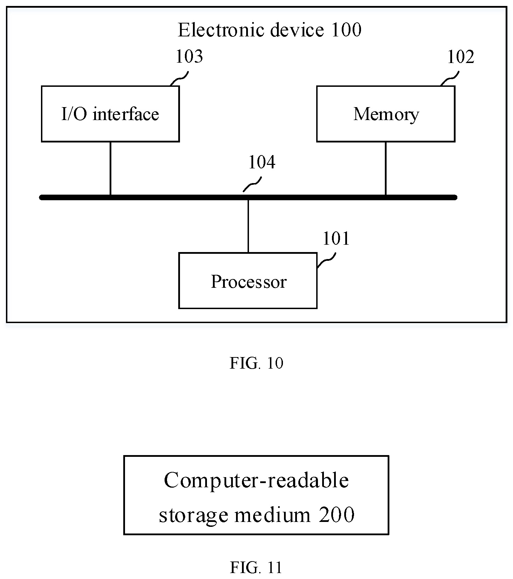

An embodiment of the present disclosure further provides an electronic device 100 which, as shown in FIG. 10, may include: one or more processors 101; a memory 102 having one or more programs stored thereon which, when executed by the one or more processors 101, cause the one or more processors 101 to conduct the heat dissipation method as described above; and one or more input/output, I/O interfaces 103 connected between the one or more processors 101 and the memory 102 and configured to enable information interaction between the one or more processors 101 and the memory 102.

The processor 101 is a device with a data processing capability, including but not limited to a central processing unit (CPU) The memory 102 is a device with a data storage capability, including but not limited to, a random access memory (RAM, more specifically SDRAM, DDR, etc.), a read-only memory (ROM), an electrically erasable programmable read-only memory (EEPROM) or a flash memory (FLASH). The I/O interface (read/write interface) 103 is connected between the processor 101 and the memory 102 to enable information interaction between the processor 101 and the memory 102, and includes, but is not limited to, a data bus or the like.

In some embodiments, the processor 101, the memory 102, and the I/O interface 103 are interconnected via a bus 104, and further connected to other components of a computing device.

An embodiment of the present disclosure further provides a computer-readable storage medium 200. As shown in FIG. 11, the computer-readable storage medium 200 has a computer program stored thereon which, when executed by a processor, causes the heat dissipation method described above to be implemented.

Those of ordinary skill in the art will appreciate that all or some operations, functional modules/units in the system and apparatus disclosed above may be implemented as software, firmware, hardware, and suitable combinations thereof.

In a hardware implementation, the division between the functional modules/units mentioned in the above description does not necessarily correspond to the division of physical components; for example, one physical component may have multiple functions, or one function or operation may be performed cooperatively by several physical components.

Some or all physical components may be implemented as software executed by a processor, such as a central processing unit (CPU), a digital signal processor or microprocessor, or implemented as hardware, or implemented as an integrated circuit, such as an application specific integrated circuit. Such software may be distributed on a computer-readable medium which may include a computer storage medium (or non-transitory medium) and a communication medium (or transitory medium). As is well known to those of ordinary skill in the art, the term computer storage medium includes volatile and nonvolatile, removable and non-removable media implemented in any method or technology for storing information, such as computer-readable instructions, data structures, program modules or other data. The computer storage medium includes, but is not limited to, a random access memory (RAM, more specifically SDRAM, DDR, etc.), a read only memory (ROM), an electrically erasable programmable read-only memory (EEPROM), a flash memory (FLASH), or other disk storage; a compact disk read-only memory (CD-ROM), a digital versatile disk (DVD), or other optical disk storage; a magnetic cassette, a magnetic tape, a magnetic disk memory or any other magnetic storage; or any other medium which can be used to store the desired information and accessed by a computer. Moreover, it is well known to those of ordinary skill in the art that a communication medium typically includes a computer-readable instruction, a data structure, a program module, or other data in a modulated data signal, such as a carrier wave or other transport mechanism, and may include any information delivery medium.

The present disclosure has disclosed exemplary embodiments, and although specific terms are employed, they are used and should be interpreted merely in a generic and descriptive sense, not for purposes of limitation. In some instances, as would be apparent to one skilled in the art, features, characteristics and/or elements described in connection with a particular embodiment may be used alone or in combination with features, characteristics and/or elements described in connection with another embodiment, unless expressly stated otherwise. It will, therefore, be understood by those skilled in the art that various changes in form and details may be made therein without departing from the scope of the present disclosure as set forth in the appended claims.

## Claims

1. A heat dissipation system, comprising: a piezoelectric heat dissipation apparatus, a natural heat dissipation apparatus, a temperature sensor, and a control unit; wherein the piezoelectric heat dissipation apparatus and the natural heat dissipation apparatus are disposed on a heat source of a device to be cooled, and the control unit is electrically connected to the temperature sensor and the piezoelectric heat dissipation apparatus, respectively;
the temperature sensor is configured to sense a temperature of the heat source;
the natural heat dissipation apparatus is configured to conduct natural heat dissipation;
the piezoelectric heat dissipation apparatus is configured to conduct natural heat dissipation, and conduct airflow heat dissipation by means of a piezoelectric effect; and
the control unit is configured to acquire the temperature of the heat source, and control, under the condition that the temperature of the heat source is higher than or equal to a preset temperature threshold, the piezoelectric heat dissipation apparatus to operate and generate an airflow, so that the natural heat dissipation apparatus and the piezoelectric heat dissipation apparatus conduct airflow heat dissipation; and control, under the condition that the temperature of the heat source is lower than the temperature threshold, the piezoelectric heat dissipation apparatus to stop operating so that the natural heat dissipation apparatus and the piezoelectric heat dissipation apparatus conduct natural heat dissipation.

2. The heat dissipation system according to claim 1, wherein the piezoelectric heat dissipation apparatus comprises at least one swingable first fin, a piezoelectric sheet for driving the first fin to swing, and a piezoelectric power supply apparatus; the first fin is connected to the piezoelectric sheet, and the piezoelectric sheet is electrically connected to the piezoelectric power supply apparatus; the control unit is electrically connected to the piezoelectric power supply apparatus; the natural heat dissipation apparatus comprises at least one second fin;
the control unit controlling the piezoelectric heat dissipation apparatus to operate and generate an airflow, so that the natural heat dissipation apparatus and the piezoelectric heat dissipation apparatus conduct airflow heat dissipation comprises:
controlling the piezoelectric power supply apparatus to supply power to the piezoelectric sheet, so that the piezoelectric sheet vibrates to drive the first fin to swing, and takes away heat from the first fin and the second fin through an airflow generated by the swing of the first fin; and
the control unit controlling the piezoelectric heat dissipation apparatus to stop operating so that the natural heat dissipation apparatus and the piezoelectric heat dissipation apparatus conduct natural heat dissipation comprises:
controlling the piezoelectric power supply apparatus to cut off power to the piezoelectric sheet, so that the piezoelectric sheet stops vibrating, the first fin stops swinging, and the first fin and the second fin conduct natural heat dissipation.

3. The heat dissipation system according to claim 2, wherein the control unit is further configured to adjust the supply voltage of the piezoelectric power supply apparatus in accordance with the temperature of the heat source, so as to adjust a swinging frequency of the first fin through a change in the supply voltage.

4. The heat dissipation system according to claim 2 or 3, wherein
the first fin is disposed on the second fin; and/or
the piezoelectric sheet is integrally formed with the first fin, and the first fin serves as the piezoelectric sheet.

5. The heat dissipation system according to any one of claims 1 to 4, wherein the heat dissipation system further comprises: a window control apparatus which is electrically connected to the control unit;
the device to be cooled comprises a housing in which the heat source is located, and the housing is provided with at least one window and a window baffle for covering the window; and
the window control apparatus is configured to control, under the control of the control unit, the window baffle to move to open or close the window.

6. The heat dissipation system according to claim 5, wherein
the control unit is further configured to conduct, under the condition that the temperature of the heat source is higher than or equal to the temperature threshold, first control on the window control apparatus to control the window baffle to open the window ; and conduct, under the condition that the temperature of the heat source is lower than the temperature threshold, second control on the window control apparatus to control the window baffle to close the window.

7. The heat dissipation system according to claim 6, wherein the window control apparatus comprises: a relay, a spring and a relay power supply apparatus;
a first end of the window baffle is connected to a first end of the spring, and a second end of the spring is fixed to the housing;
a second end of the window baffle is connected to a movable contact of the relay;
the relay is electrically connected to the relay power supply apparatus; and
the relay power supply apparatus is electrically connected to the control unit.

8. The heat dissipation system according to claim 7, wherein the control unit conducting first control on the window control apparatus to control the window baffle to open the window comprises:
controlling the relay power supply apparatus to supply power to the relay, so that the window baffle is pulled to move in a first direction through pull-in of the relay, thereby opening the window; and
the control unit conducting second control on the window control apparatus to control the window baffle to close the window comprises:
controlling the relay power supply apparatus to cut off power to the relay, so that the spring pulls the window baffle to move in a second direction through release of the relay, thereby closing the window.

9. A heat dissipation method based on the heat dissipation system according to any one of claims 1 to 8 and applied to a control unit of the heat dissipation system, wherein the method comprises:
acquiring a temperature of a heat source in a device to be cooled;
under the condition that the temperature of the heat source is higher than or equal to a preset temperature threshold, controlling a piezoelectric heat dissipation apparatus of the heat dissipation system to operate and generate an airflow, so that the natural heat dissipation apparatus and the piezoelectric heat dissipation apparatus conduct airflow heat dissipation; and under the condition that the temperature of the heat source is lower than the temperature threshold, controlling the piezoelectric heat dissipation apparatus to stop operating so that the natural heat dissipation apparatus and the piezoelectric heat dissipation apparatus conduct natural heat dissipation.

10. The heat dissipation method according to claim 9, wherein controlling the piezoelectric heat dissipation apparatus of the heat dissipation system to operate and generate an airflow, so that the natural heat dissipation apparatus and the piezoelectric heat dissipation apparatus conduct airflow heat dissipation comprises:
controlling a piezoelectric power supply apparatus of the piezoelectric heat dissipation apparatus to supply power to a piezoelectric sheet of the piezoelectric heat dissipation apparatus, so that the piezoelectric sheet vibrates to drive a first fin of the piezoelectric heat dissipation apparatus to swing, and takes away heat from the first fin and a second fin of the natural heat dissipation apparatus through an airflow generated by the swing of the first fin; and
controlling the piezoelectric heat dissipation apparatus to stop operating so that the natural heat dissipation apparatus and the piezoelectric heat dissipation apparatus conduct natural heat dissipation comprises:
controlling the piezoelectric power supply apparatus to cut off power to the piezoelectric sheet, so that the piezoelectric sheet stops vibrating, the first fin stops swinging, and the first fin and the second fin conduct natural heat dissipation.

11. The heat dissipation method according to claim 10, further comprising:
adjusting a supply voltage of the piezoelectric power supply apparatus in accordance with the temperature of the heat source, so as to adjust a swinging frequency of the first fin through a change in the supply voltage.

12. The heat dissipation method according to any one of claims 9 to 11, further comprising:
under the condition that the temperature of the heat source is higher than or equal to the temperature threshold, conducting first control on a window control apparatus of the heat dissipation system to control a window baffle of the device to be cooled to open a window on a housing of the device to be cooled; and under the condition that the temperature of the heat source is lower than the temperature threshold, conducting second control on the window control apparatus to control the window baffle to close the window.

13. The heat dissipation method according to claim 12, wherein conducting first control on the window control apparatus of the heat dissipation system to control the window baffle of the device to be cooled to open the window on the housing of the device to be cooled comprises:
controlling a relay power supply apparatus of the window control apparatus to supply power to a relay of the window control apparatus, so that the window baffle is pulled to move in a first direction through pull-in of the relay, thereby opening the window;
conducting second control on the window control apparatus to control the window baffle to close the window comprises:
controlling the relay power supply apparatus to cut off power to the relay, so that a spring of the window control apparatus pulls the window baffle to move in a second direction through release of the relay, thereby closing the window.

14. A device to be cooled, comprising: a heat source and the heat dissipation system according to any one of claims 1 to 8; wherein the heat dissipation system is configured for heat dissipation of the heat source.

15. An electronic device, comprising:
one or more processors;
a memory having one or more programs stored thereon which, when executed by the one or more processors, cause the one or more processors to implement the heat dissipation method according to any one of claims 9 to 13; and
one or more input/output, I/O interfaces connected between the one or more processors and the memory and configured to enable information interaction between the one or more processors and the memory.

16. A computer-readable storage medium having a computer program stored thereon which, when executed by a processor, causes the heat dissipation method according to any one of claims 9 to 13 to be implemented.
